# EUROPEAN PATENT APPLICATION

(11) **EP 2 552 181 A2**
(43) Date of publication of application: **30.01.2013**
(21) Application number: 12173522.9
(22) Date of filing: 26.06.2012
(51) Int. Cl.: H05K 5/00

(54) **Electronic control unit and vehicle steering system**

(30) Priority: 01.07.2011 JP 2011147380
(71) Applicant: JTEKT CORPORATION, Osaka-shi Osaka 542-8502 (JP)
(72) Inventor: Ishikawa, Ryuji, Osaka-shi,, Osaka 542-8502 (JP)
(74) Representative: TBK

(57) **Abstract**

An electronic control unit (11) includes a control board (22) that is fixed to a heat sink (21) that serves as a base, and a case (23) that is fitted to the heat sink (21) to close its open end (25) to thereby form an accommodation space (X) for the control board (22). Further, the case (23) has a folded-back portion (30) that is folded back from the open end (25) into the case (23) and that elastically contacts the heat sink (21).

## Description

### BACKGROUND OF THE INVENTION

### 1. Field of the Invention

The invention relates to an electronic control unit and a vehicle steering system. 2. Discussion of Background

Many electronic control units mounted in vehicles have a box-shaped case. A control board is accommodated in the case to prevent failures that may occur, for example, if foreign matter adheres to the control board or the control board gets wet.

In some electronic control units, a case is fitted to a base, to which a control board is fixed, to close the open end of the case. In this way, an accommodation space for the control board is formed. Conventionally, the case is usually fixed to the base with bolts.

However, if it is possible to fix a case to a base without fastening, not only the thread fastening process is omitted but also threaded holes and a flange that are required for fastening and the process of forming these threaded holes and flange are omitted. Thus, it is possible to significantly simplify the configuration and reduce man-hour.

Therefore, for example, a curved portion that is convex inward, as shown in FIG. 6 of US Patent No. 5099396, is formed at the open end of a case. Then, the case is attached to a base by press-fitting the base to the open end. That is, because the base inserted into the open end pushes the curved portion, a case side wall is elastically deformed outward. The base is clamped between the case side walls by the elastic force. Thus, it is possible to keep the fit between the case and the base.

However, in the configuration in which elastic deformation of the case side wall due to the fit between the case and the base is utilized as described above, it is necessary to strictly manage dimensional tolerances of the case and the base so that the case side wall generates appropriate elastic force.

That is, if the elastic force of the case side wall, utilized as the retaining force, is insufficient, a gap may be formed between the case and the base, which allows entry of foreign matter and water into the case. On the other hand, if the elastic force is excessive, the curved portion may abrade a contact portion during press-fitting, and chips generated by abrasion may enter the case as a foreign matter. If strict dimensional tolerance management is carried out to avoid the above-mentioned inconvenience, the manufacturing cost increases.

### SUMMARY OF THE INVENTION

The invention provides an electronic control unit and a vehicle steering system that allow easy and reliable attachment of a case, with a simple configuration, without incurring strict tolerance management.

According to a feature of an example of the invention, a folded-back portion that is folded back from an open end of a case into the case and that elastically contacts a base is formed. The base is clamped within the case by elastic force of the folded-back portion. As a result, it is possible to keep the fit between the base and the case. In addition, the folded-back portion arranged inside the case is elastically deformed, so a body portion (side wall) of the case is hard to deform. In addition, the elastic force of the folded-back portion, which is utilized as retaining force for keeping the fit between the base and the case, is easily set by adjusting the amount of elastic deformation of the folded-back portion, which is caused when the folded-back portion is pushed by the base, that is, the shape of the folded-back portion and the angle at which the folded-back portion is folded back into the case, for example. Therefore, with the above configuration, it is possible to generate stable retaining force without carrying out strict dimensional tolerance management. As a result, it is possible to easily and reliably attach the case to the base, with a simple configuration.

### BRIEF DESCRIPTION OF THE DRAWINGS

The foregoing and further objects, features and advantages of the invention will become apparent from the following description of example embodiments with reference to the accompanying drawings, wherein like numerals are used to represent like elements and wherein:
FIG. 1 is a schematic configuration view of a vehicle steering system;
FIG. 2 is a perspective view of an electronic control unit;
FIG. 3 is an exploded perspective view of the electronic control unit;
FIG. 4 is a sectional view of the electronic control unit, taken along the line A-A in FIG. 2;
FIG. 5 is a sectional view of the electronic control unit, taken along the line B-B in FIG. 2;
FIG. 6 is a view illustrating the operation of a folded-back portion;
FIG. 7 is an enlarged sectional view of a lug portion;
FIG. 8 is a sectional view of a folded-back portion according to an alternative embodiment of the invention; and
FIG. 9 is a perspective view of a case according to an alternative embodiment of the invention.

### DETAILED DESCRIPTION OF EMBODIMENTS

Hereinafter, embodiments of the invention will be described with reference to the accompanying drawings.

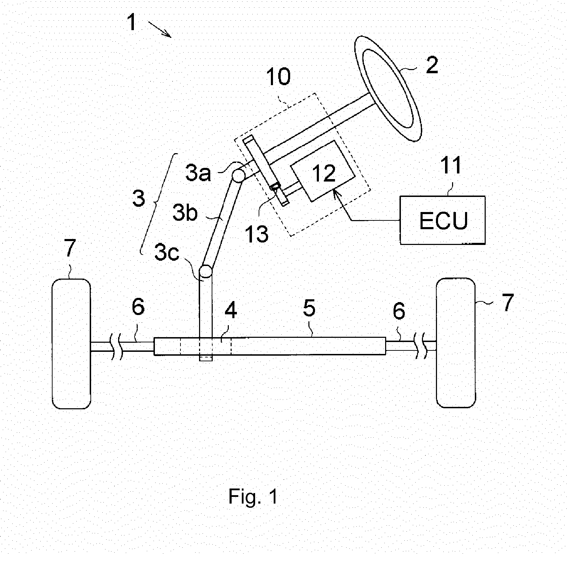

As shown in FIG. 1, in a vehicle steering system 1 according to a present embodiment of the invention, a steering shaft 3 to which a steering wheel 2 is fixed is coupled to a rack shaft 5 via a rack and pinion mechanism 4. The rotation of the steering shaft 3 resulting from a steering operation is converted into reciprocating linear motion of the rack shaft 5 by the rack and pinion mechanism 4. The steering shaft 3 according to the present embodiment is formed by coupling a column shaft 3a, an intermediate shaft 3b and a pinion shaft 3c to each other. The reciprocating linear motion of the rack shaft 5 resulting from the rotation of the steering shaft 3 is transmitted to knuckles (not shown) via tie rods 6 coupled to respective ends of the rack shaft 5. As a result, the steered angle of steered wheels 7, that is, the travelling direction of a vehicle is changed.

The vehicle steering system 1 is configured as an electric power steering system (EPS) that includes an EPS actuator 10 and an electronic control unit (ECU) 11. The EPS actuator 10 serves as a steering force assist device that applies assist force to a steering system by driving a motor 12. The ECU 11 controls the operation of the EPS actuator 10.

Specifically, the EPS actuator 10 according to the present embodiment is a so-called column assist-type EPS actuator in which the motor 12 that serves as a driving source is coupled to the column shaft 3a via a speed reduction mechanism 13. The electronic control unit 11 supplies driving electric power to the motor 12 to control the operation of the EPS actuator 10, that is, assist force that is applied to the steering system.

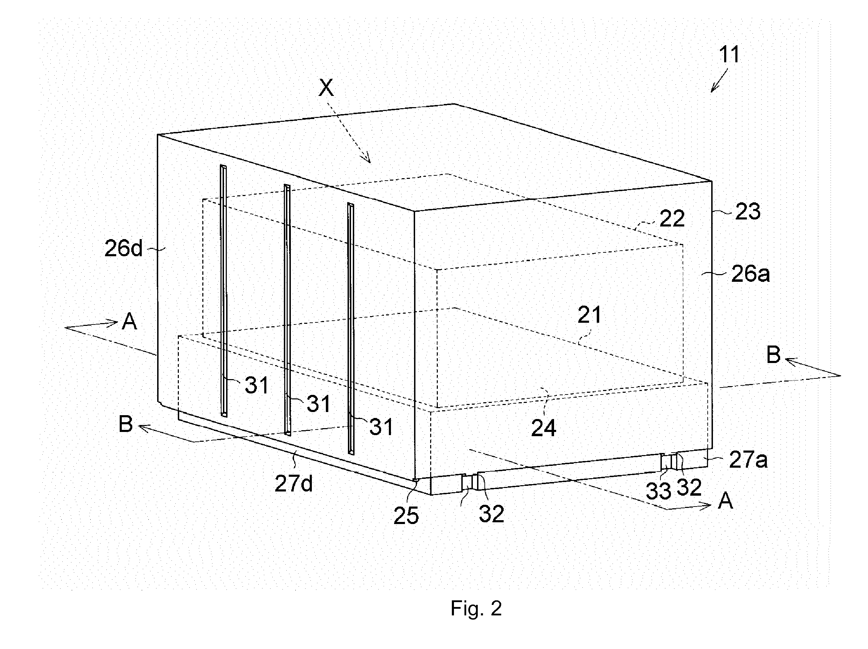

Next, the configuration of the electronic control unit will be described. As shown in FIG. 2 to FIG. 4, the electronic control unit 11 according to the present embodiment includes a control board 22 and a case 23. The control board 22 is fixed to a heat sink 21. The case 23 is attached to the heat sink 21 so that an accommodation space X for the control board 22 is formed.

More specifically, the heat sink 21 that serves as a base has a generally low-height flat box (rectangular parallelepiped) outside shape. The control board 22 according to the present embodiment has a multilevel structure in which a plurality of circuit boards and a plurality of electronic components are arranged sterically. The control board 22 is fixed to an installation surface 24 (upper face) of the heat sink 21.

The case 23 is formed into a generally rectangular box shape with an upper face. Thus, the case 23 is attached to the heat sink 21 such that an open end 25 of the case 23 is fitted to the heat sink 21. The case 23 according to the present embodiment is formed by bending a metal plate. Then, the open end 25 of the case 23 is closed by the heat sink 21. As a result, the accommodation space X for the control board 22 is formed inside the case 23.

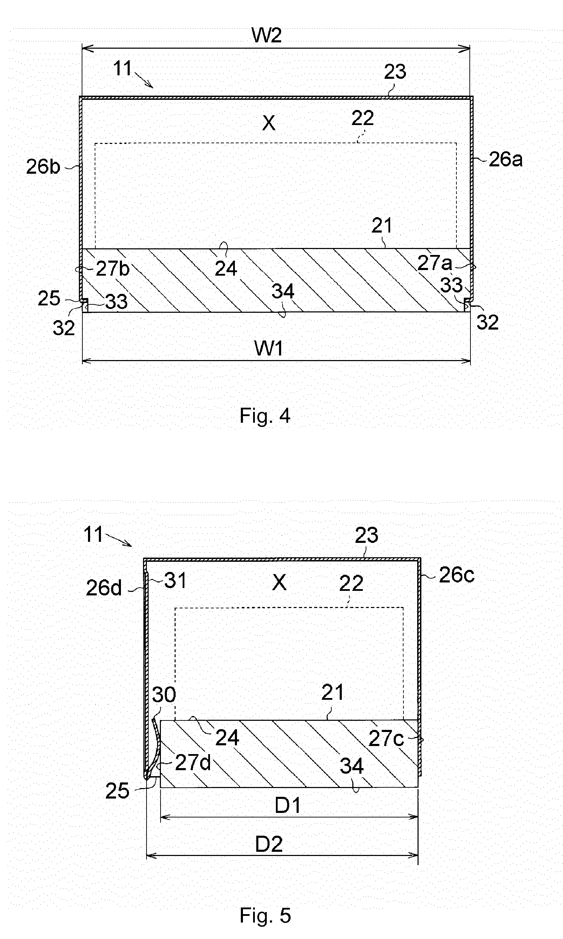

More specifically, as shown in FIG. 4 and FIG. 5, when the direction (up-down direction in the drawings) perpendicular to the installation surface 24 is set as a height direction, the heat sink 21 is formed to have a rectangular sectional shape at a plane perpendicular to the height direction. As shown in FIG. 4, when the length of the rectangular section in the longitudinal direction (right-left direction in the drawing) is a length W1 of the heat sink 21 in the widthwise direction, the case 23 is formed such that a distance W2 between side walls 26a and 26b, which are arranged in the widthwise direction when the case 23 is fitted to the heat sink 21, is substantially equal to the length W1 of the heat sink 21 in the widthwise direction.

As shown in FIG. 5, when the length of the rectangular section in the lateral direction (right-left direction in the drawing) is a length D1 of the heat sink 21 in the depth direction, a distance D2 between side walls 26c and 26d of the case 23, which are arranged in the depth direction when the case 23 is fitted to the heat sink 21, is set to a value larger than the length D 1 of the heat sink 21 in the depth direction. The one side wall 26d arranged in the depth direction has a folded-back portion 30 that is folded back from the open end 25 to bulge inward within the case 23.

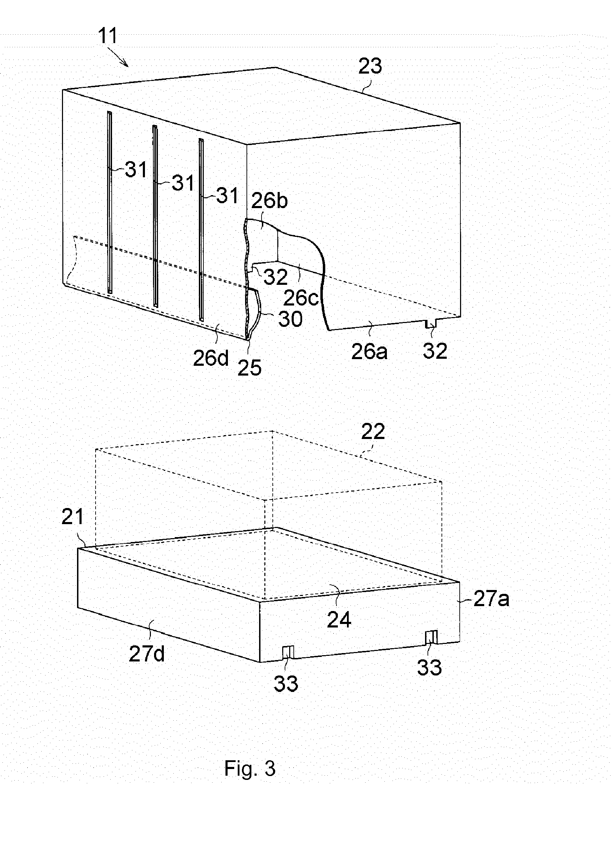

Specifically, the folded-back portion 30 is folded back from the open end 25 at an acute angle. Thus, folded-back portion 30 is substantially entirely arranged inside the case 23. In addition, the folded-back portion 30 is formed to be curved and convex toward the side wall 26c (convex rightward in FIG. 5) that faces the side wall 26d at which the folded-back portion 30 is formed. As shown in FIG. 3, the folded-back portion 30 is formed over substantially the entire width of the side wall 26d between the side wall 26a and the side wall 26b that are located at respective sides of the side wall 26d in the widthwise direction.

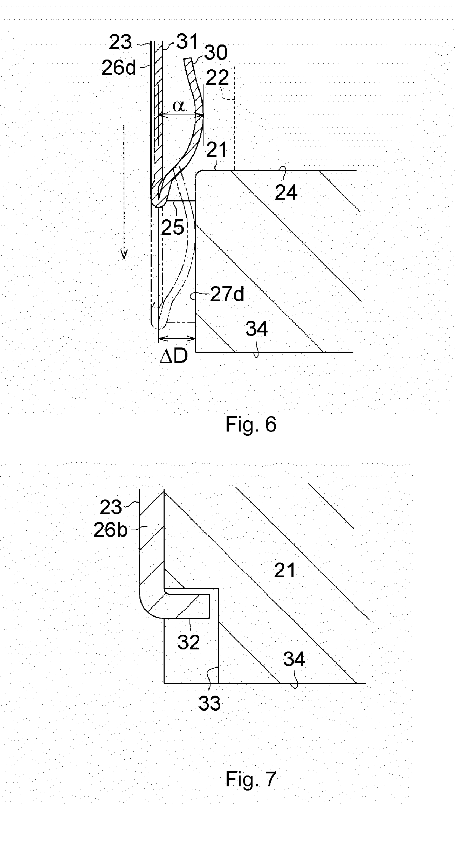

In addition, as shown in FIG. 6, the folded-back portion 30 is formed such that, before the case 23 is fitted to the heat sink 21, a bulge amount α of the folded-back portion 30 in a direction in which the folded-back portion 30 faces the heat sink 21 (rightward in the drawing) when the case 23 is fitted to the heat sink 21 is larger than a difference ΔD between the distance D2 between the side walls 26c and 26d of the case 23 and the length D1 of the heat sink 21 in the depth direction (ΔD = D2 - D1, α > ΔD). The open end 25 of the case 23 is press-fitted to the heat sink 21.

At the time of press-fitting, the inner faces of the side walls 26a to 26c of the case 23 slidingly contact the side faces 27a to 27c of the heat sink 21, respectively. In addition, the folded-back portion 30 provided at the side wall 26d contacts the remaining side face 27d of the heat sink 21. Then, the folded-back portion 30 is pushed by the side face 27d of the heat sink 21 to be elastically deformed toward the side wall 26d such that the curved shape of the contact portion is depressed.

The case 23 according to the present embodiment is formed such that the heat sink 21 is clamped between the folded-back portion 30 and the side wall 26c by the elastic force generated by the folded-back portion 30. With this configuration, it is possible to keep the fit between the case 23 and the heat sink 21.

Furthermore, as shown in FIG. 3 and FIG. 5, the side wall 26d having the folded-back portion 30 has a plurality of ribs 31 that reinforce the side wall 26d. Specifically, the three ribs 31 that protrude inward in the depth direction of the case 23 are formed on the side wall 26d by press working, and the ribs 31 extend in the height direction of the side wall 26d. With this configuration according to the present embodiment, deformation of the side wall 26d is suppressed.

In addition, as shown in FIG. 2, the case 23 has a plurality of lug portions 32 that engage with the heat sink 21. More specifically, as shown in FIG. 2 to FIG. 4 and FIG. 7, the lug portions 32 are formed so as to protrude from the open end 25 of the case 23 downward (downward in the drawing) in the height direction of the case 23. In the present embodiment, two lug portions 32 are formed at each of the side walls 26a and 26b that are located on respective sides of the folded-back portion 30 in the widthwise direction. A plurality of engagement recesses 33 that correspond to the lug portions 32 are formed in the heat sink 21. Specifically, two engagement recesses 33 are formed in each of the side faces 27a and 27b of the heat sink 21 that slidingly contact the side walls 26a and 26b at which the lug portions 32 are formed. Each of the engagement recesses 33 is open at a bottom face 34 of the heat sink 21, and is not open at the installation surface 24 that faces the direction in which the case 23 is attached to the heat sink 21.

The distal end of each lug portion 32 is bent into a corresponding one of the engagement recesses 33. In this way, the lug portions 32 engage with the heat sink 21. With this configuration according to the present embodiment, it is possible to ensure the fit between heat sink 21 and the case 23.

As described above, according to the present embodiment, the following advantageous effects are obtained. (1) The electronic control unit 11 includes the control board 22 and the case 23. The control board 22 is fixed to the heat sink 21 that serves as the base. The case 23 is fitted to the heat sink 21 to close the open end 25 of the case 23. As a result, the accommodation space X for the control board 22 is formed. Further, the case 23 has the folded-back portion 30 that is folded back from the open end 25 inward within the case 23 and that elastically contacts the heat sink 21.

With the above configuration, the heat sink 21 is clamped between the folded-back portion 30 and the side wall 26c by the elastic force generated by the folded-back portion 30. With this configuration, it is possible to keep the fit between the case 23 and the heat sink 21. In addition, the folded-back portion 30 arranged inside the case 23 is elastically deformed, so the body portion (the side walls 26a to 26d) of the case 23 is hard to deform. In addition, the elastic force of the folded-back portion 30, which is utilized as retaining force for keeping the fit between the heat sink 21 and the case 23, is easily set by adjusting the amount of elastic deformation of the folded-back portion 30, which is caused when the folded-back portion 30 is pushed by the heat sink 21, that is, the shape of the folded-back portion 30 and the angle at which the folded-back portion 30 is folded back into the case 23, for example. Therefore, with the above configuration, it is possible to generate stable retaining force without carrying out strict dimensional tolerance management. As a result, it is possible to easily and reliably attach the case 23 to the heat sink 21, with a simple configuration.

(2) The folded-back portion 30 is formed to be curved such that the portion that contacts the heat sink 21 is convex. With this configuration, at the time of press-fitting, the folded-back portion 30 is elastically deformed smoothly without being caught on the heat sink 21. Thus, load management at the time of press-fitting is easily carried out, and elastic force generated by the folded-back portion 30 becomes further stable. Further, machining the heat sink 21, such as forming a tapered face at a portion that contacts the case 23 at the initial stage of press-fitting, is also not required. As a result, it is possible to further simply and reliably attach the case 23 to the heat sink 21.

(3) The side wall 26d of the case 23 has the ribs 31 that reinforce the side wall 26d. Thus, deformation of the case 23 is suppressed, which further facilitates the tolerance management for the case 23. In addition, the elastic force of the folded-back portion 30 is stabilized by reinforcing the side wall 26d at which the folded-back portion 30 is formed. As a result, it is possible to further easily and reliably attach the case 23 to the heat sink 21.

(4) The case 23 has the lug portions 32 that engage with the heat sink 21. Thus, it is possible to ensure the fit between the case 23 and the heat sink 21.

Alternative embodiments of the invention will be described below. In the above embodiment, the invention is applied to the electronic control unit 11 of the vehicle steering system 1 that is configured as an electric power steering system (EPS). However, the invention is not limited to this configuration. For example, the invention may be applied to an electronic control unit provided on a vehicle steering system, other than the electronic control unit of the EPS, such as an electronic control unit of a variable transmission ratio device. The invention may also be applied to an electronic control unit used in a system other than the vehicle steering system.

In the above embodiment, the control board 22 is fixed to the installation surface 24 that is set to one face of the heat sink 21 that serves as the base. However, the invention is not limited to this configuration. For example, any structural bodies other than heat sink 21, such as a motor housing, may be adopted as the base, as long as a control board is fixed to the structural body and the structural body is shaped so as to be fitted to a case.

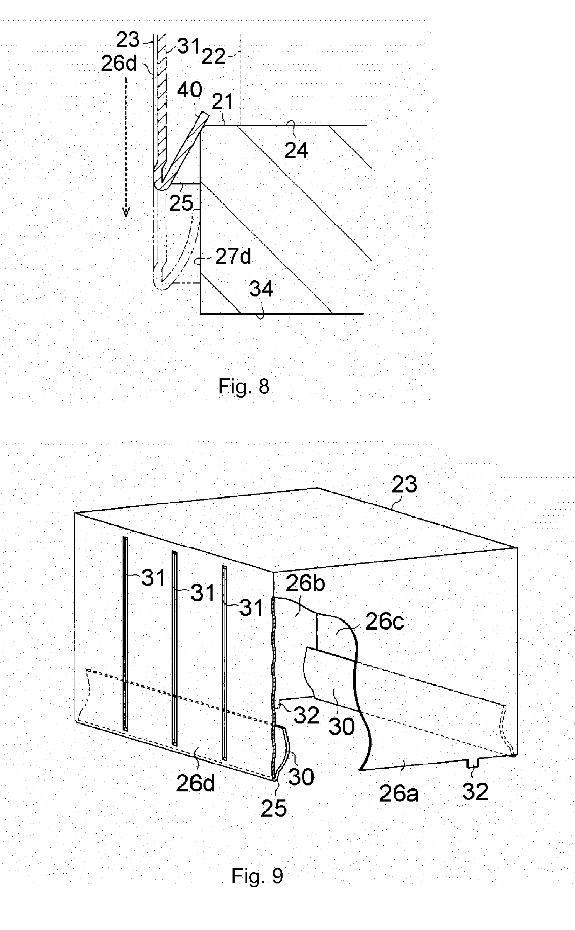

In the above embodiment, the folded-back portion 30 is formed to be curved such that the portion that contacts the heat sink 21 is convex. However, the invention is not limited to this configuration. As in the case of a folded-back portion 40 shown in FIG. 8, the folded-back portion 40 may be linearly folded back from the open end 25.

In the above embodiment, the folded-back portion is formed at the side wall 26d that is arranged on one side in the depth direction when the case 23 is fitted to the heat sink 21. However, the invention is not limited to this configuration. For example, as shown in FIG. 9, two folded-back portions 30 may be formed at the respective side walls 26c and 26d that are opposed to each other and the heat sink 21 may be clamped between the two folded-back portions 30 to thereby ensure the fit between the case 23 and the heat sink 21. Thus, dimensional tolerance management is further easily carried out. Furthermore, portions at which the folded-back portions 30 are formed and the number of the folded-back portions 30 may be changed as needed. For example, the folded-back portions 30 may be formed at a plurality of adjacent side walls or all the side walls.

In the above embodiment, the case 23 is formed in a closed-end generally rectangular box shape that corresponds to the shape (rectangular parallelepiped shape) of the heat sink 21 to which the open end 25 is fitted. However, the invention is not limited to this configuration. The open end of the case 23 may be in any shapes such as polygonal shapes other than a rectangular shape, as long as the case 23 is formed such that the open end of the case 23 is fitted to the base to form an accommodation chamber for the control board and the folded-back portion is formed at the open end with the hermetically sealed state of the accommodation chamber (state where the open end is closed) maintained.

In the above embodiment, the side wall 26d at which the folded-back portion 30 is formed has the plurality of ribs 31 that extend in the height direction. However, the invention is not limited to this configuration. For example, the ribs 31 may be formed on the other side walls 26a to 26c with no folded-back portion 30. Further, the shape of each rib 31 may also be changed as appropriate.

In the above embodiment, two lug portions 32 that protrude from the open end 25 are formed on each of the side walls 26a and 26b located on respective sides of the folded-back portion 30 in the widthwise direction. However, portions at which the lug portions are formed, the number of the lug portions, a manner for engaging the lug portions with the base, and the like, may be changed as needed, as long as the lug portions engage with the heat sink 21 that serves as the base to prevent removal of the case 23 from the heat sink 21.
An electronic control unit (11) includes a control board (22) that is fixed to a heat sink (21) that serves as a base, and a case (23) that is fitted to the heat sink (21) to close its open end (25) to thereby form an accommodation space (X) for the control board (22). Further, the case (23) has a folded-back portion (30) that is folded back from the open end (25) into the case (23) and that elastically contacts the heat sink (21).

## Claims

1. An electronic control unit, comprising:
a control board that is fixed to a base; and
a case that is fitted to the base to close an open end of the case to thereby form an accommodation space for the control board, wherein
the case has a folded-back portion that is folded back from the open end into the case and that elastically contacts the base.

2. The electronic control unit according to claim 1, wherein
the folded-back portion is formed to be curved such that a portion of the folded-back portion which contacts the base is convex.

3. The electronic control unit according to claim 1 or claim 2, wherein
a rib that reinforces a side wall of the case is formed on the side wall.

4. The electronic control unit according to any one of claim 1 to claim 3, wherein
the case has a lug portion that engages with the base.

5. A vehicle steering system comprising the electronic control unit according to any one of claims 1 to 4.
